# EUROPÄISCHE PATENTSCHRIFT

(11) **EP 1 750 300 B1**
(45) Veröffentlichungstag und Bekanntmachung des Hinweises auf die Patenterteilung: **01.12.2010**
(21) Anmeldenummer: 06014879.8
(22) Anmeldetag: 18.07.2006
(51) Int. Cl.: H01L 23/10, H01L 25/07

(54) **Elektrisches Bauteil**
Electrical element
Dispositif électrique

(30) Priorität: 01.08.2005 DE 102005036105
(43) Veröffentlichungstag der Anmeldung: 07.02.2007
(73) Patentinhaber: Semikron Elektronik GmbH & Co. KG Patentabteilung, 90431 Nürnberg (DE)
(72) Erfinder: Thomas, Frank, 91207 Lauf (DE)

(56) Entgegenhaltungen:
- EP-A- 0 924 845
- DE-A1- 10 119 939
- DE-C1- 10 127 947
- DE-C1- 10 141 114
- US-A- 5 523 620

## Beschreibung

Die Erfindung betrifft ein elektrisches Bauteil mit mindestens einer Stromschiene, die zwischen einem ersten und einem zweiten Gehäuseteil vorgesehen ist, und die mit einem äusseren Stromanschluss-Element kontaktierbar ist.

Das erste Gehäuseteil des elektrischen Bauteils kann hierbei z.B. eine Grundplatte und das zweite Gehäuseteil ein Deckel sein, die gemeinsam ein Gehäuse des Bauteils bilden. Bei dem elektrischen Bauteil handelt es sich z.B. um ein Leistungsmodul wie einen IGBT- oder MOSFET-Leistungsmodul. Derartige elektrische Bauteile sind in einer Vielzahl Ausbildungen an sich bekannt. Beispielsweise beschreiben die DE 101 27 947 C1 und die DE 101 41 114 C1 solche elektrische Bauteile.

Bei bekannten elektrischen Bauteilen der eingangs genannten Art werden die Stromschienen beispielsweise zwischen der Grundplatte und dem Deckel des Gehäuses heraus geführt. Zur Abdichtung ist eine Dichtung vorgesehen, die zwischen dem Deckel und der Grundplatte und der Stromschiene vorgesehen ist. Infolge von Abmessungs-Toleranzen ergibt sich jedoch der Mangel, dass eine wasserdichte Abdichtung kaum bzw. nur mit entsprechendem Aufwand realisierbar ist.

Eine andere bekannte Möglichkeit besteht darin, die jeweilige Stromschiene mit einem Anschlusszapfen zu kombinieren, der aus dem Gehäuse heraus ragt. Derartige Anschlusszapfen ergeben jedoch zwischen ihnen und den zugehörigen Stromschienen Übergangswiderstände, aus welchen entsprechende Energieverluste resultieren.

Der Erfindung liegt die Aufgabe zugrunde, ein elektrisches Bauteil der eingangs genannten Art zu schaffen, mit dem die oben genannten Mängel beseitigt, d.h. bei einem einfachen Aufbau eine zuverlässige Abdichtung bewirkt und ein Übergangswiderstand vermieden wird.

Diese Aufgabe wird bei einem elektrischen Bauteil der eingangs genannten Art erfindungsgemäss dadurch gelöst, dass die Stromschiene mit einer aus ihrer Grundfläche heraus ragenden Noppe ausgebildet ist, die einen kreisrunden Kontaktring-Stirnflächenabschnitt mit einem Durchgangsloch und einen kreiszylindrischen Mantelabschnitt aufweist, wobei der Kontaktring-Stirnflächenabschnitt von der Grundfläche der Stromschiene eine definierte Höhenabmessung besitzt, dass das erste Gehäuseteil ein Loch aufweist, aus dem die Noppe mit ihrem Kontaktring-Stirnflächenabschnitt definiert vorsteht und das Loch mit einer umlaufenden Ausnehmung ausgebildet ist, in der ein Dichtungsring abdichtend vorgesehen ist, und dass ein Befestigungselement sich durch das Durchgangsloch des Kontaktring-Stirnflächenabschnittes der Noppe hindurch erstreckt und aus der Noppe vorsteht und zur mechanisch festen Anschlusskontaktierung des Stromanschlusselementes an dem Kontaktring-Stirnflächenabschnitt der Noppe vorgesehen ist.

Bei dem Stromanschlusselement handelt es sich z.B. um einen Kabelschuh eines Anschlusskabels oder um eine Stromverschienung.

Die Noppe und die Stromschiene sind vorzugsweise materialeinstückig ausgebildet, d.h. die Grundfläche der Stromschiene wird vorzugsweise entsprechend umgeformt, um die Noppe auszubilden.

Bevorzugt ist es hierbei, wenn die Grundfläche der Stromschiene einen länglich rechteckigen Querschnitt mit einer bestimmten Schienenbreite besitzt, und wenn die kreiszylindrische Außenmantelfläche der Noppe einen Durchmesser besitzt, der kleiner ist als die Schienenbreite. Auf diese Weise werden unerwünschte Verformungen der Grundfläche der Stromschiene neben der umgeformten Noppe vermieden.

Bevorzugt ist es, wenn das Durchgangsloch im Zentrum des Kontaktring-Stirnflächenabschnittes der Noppe ausgebildet ist, um symmetrische Verhältnisse zu realisieren.

Bei dem erfindungsgemässen elektrischen Bauteil weist das sich durch die Noppe der Stromschiene erstreckende Befestigungselement vorzugsweise einen Widerlagerabschnitt auf, der an der Innenfläche der Noppe anliegt, so dass zwischen dem Widerlagerabschnitt und der Noppe eine formschlüssige Verbindung gegeben ist. Damit ergibt sich der Vorteil einer exakten Positionierung des Befestigungselementes.

Das Befestigungselement weist zweckmäßigerweise einen Gewindezapfen auf, der vom Widerlagerabschnitt einstückig weg steht, und der aus dem zentralen Durchgangsloch des Kontaktring-Stirnflächenabschnittes der Noppe definiert vorsteht. Auf den Gewindezapfen kann nach dem Anbringen des Stromanschlusselementes eine Schraubmutter und zur Sicherung ggf. eine Kontermutter aufgeschraubt werden, um das Stromanschlusselement sicher und zuverlässig an der Noppe der Stromschiene zu befestigen.

Bei dem erfindungsgemässen elektrischen Bauteil kann die umlaufende Ausnehmung im Loch des ersten Gehäuseteiles von einer Rille gebildet sein, die zur radial abdichtenden Vorspannung des Dichtungsringes zwei sich gegenüber liegende, radial orientierte Ringflächen und eine axial orientierte Grundfläche aufweist. Eine andere Möglichkeit besteht darin, dass die umlaufende Ausnehmung im Loch des ersten Gehäuseteils von einer Aussparung gebildet ist, die zur axial abdichtenden Verspannung des Dichtungsringes eine einzige radial orientierte Ringfläche und eine axial orientierte Grundfläche aufweist.

Zweckmäßig ist es, wenn das erste Gehäuseteil mit einer ringförmigen Rinne ausgebildet ist, in der ein zweiter Dichtungsring vorgesehen ist, der in der Nachbarschaft der Noppe der Stromschiene gegen diese drückt.

Das erfindungsgemäße elektrische Bauteil weist gegenüber dem Stand der Technik einen vergleichsweise einfachen Aufbau des Anschlusselementes auf. Weitere Vorteile bestehen darin, dass eine zuverlässige Abdichtung des Gehäuses gewährleistet wird und dass der Übergangswiderstand vergleichsweise klein ist, weil die Stromschiene mittels der mit ihr einteilig ausgebildeten Noppe direkt mit dem entsprechenden äusseren Stromanschlusselement kontaktierbar ist.

Weitere Einzelheiten, Merkmale und Vorteile ergeben sich aus der nachfolgenden Beschreibung eines in der Zeichnung dargestellten Ausführungsbeispieles des erfindungsgemässen elektrischen Bauteiles bzw. wesentlicher Einzelheiten desselben.

Es zeigen -:
- Figur 1: eine räumliche Darstellung einer Ausbildung des elektrischen Bauteils,
- Figur 2: einen Schnitt entlang der Schnittlinie II-II in Figur 1, und
- Figur 3: eine räumliche Darstellung eines Abschnittes einer Stromschiene des elektrischen Bauteils gemäss den Figuren 1 und 2.

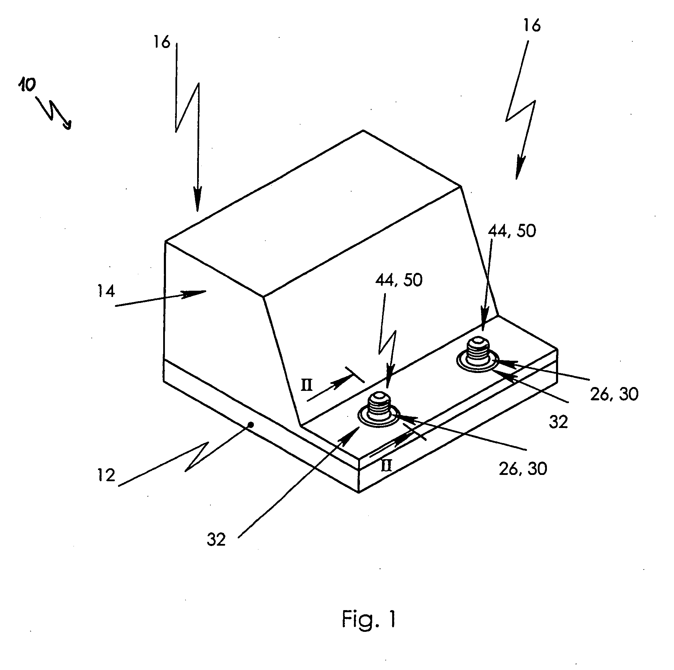

Figur 1 zeigt eine Ausführungsform des elektrischen Bauteils 10, das ein erstes Gehäuseteil 12 und ein zweites Gehäuseteil 14 aufweist. Das erste Gehäuseteil 12 ist beispielsweise als Grundplatte und das zweite Gehäuseteil 14 als Deckel ausgebildet, die miteinander zu einem elektrisch isolierenden Gehäuse 16 verbunden sind.

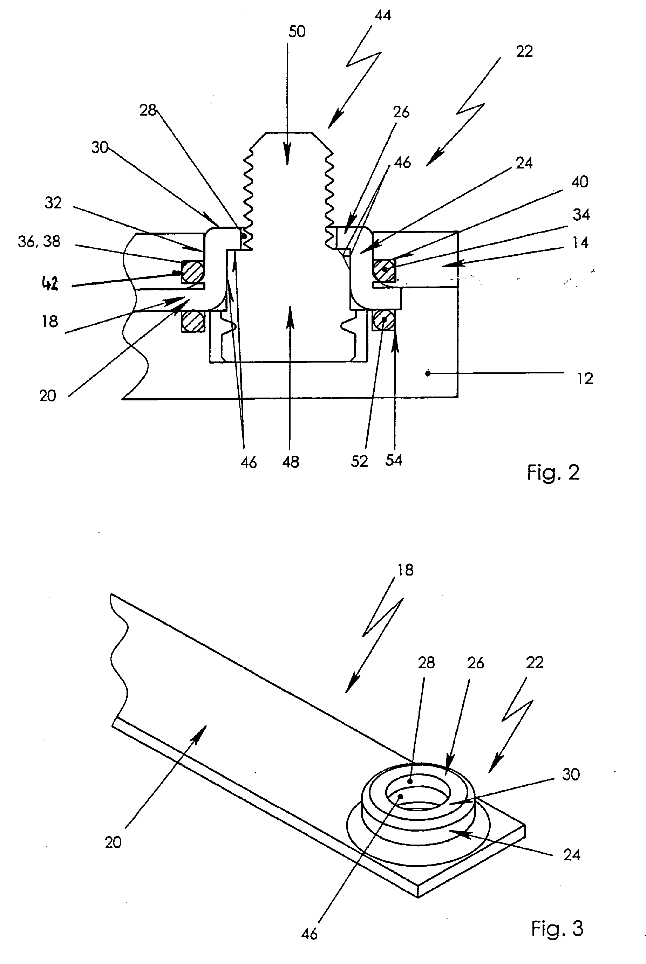

Zwischen dem ersten und dem zweiten Gehäuseteil 12 und 14 sind Stromschienen 18 vorgesehen, von welchen in den Figuren 2 und 3 eine Stromschiene 18 abschnittweise dargestellt ist. Die jeweilige Stromschiene 18 weist eine Grundfläche 20 auf, aus der eine Noppe 22 heraus ragt. Die Noppe 22 ist durch Umformen der Grundfläche 20 gebildet. Bei dieser Umformung kann es sich beispielsweise um eine Kaltverformung handeln.

Die Noppe 22 weist einen an die Grundfläche 20 der Stromschiene 18 anschliessenden kreiszylindrischen Mantelabschnitt 24 und einen an diesen anschliessenden Kontaktring-Stirnflächenabschnitt 26 auf. Der Kontaktring-Stirnflächenabschnitt 26 ist mit einem zentralen Durchgangsloch 28 ausgebildet, durch das stirnseitig eine Kontaktfläche 30 definiert ist.

Das zweite Gehäuseteil 14 ist mit einem Loch 32 ausgebildet. Das Loch 32 besitzt einen Durchmesser, der an den Außendurchmesser des kreiszylindrischen Mantelabschnittes 24 der Noppe 22 angepasst ist.

Zur Abdichtung zwischen der Noppe 22 und dem zweiten Gehäuseteil 14 dient ein Dichtungsring 34. Der Dichtungsring 34 ist in einer Ausnehmung 36 angeordnet, die im zweiten Gehäuseteil 14 ausgebildet ist.

Das erste Gehäuseteil 12 ist mit einer ringförmigen Rinne 54 ausgebildet, in der ein zweiter Dichtungsring 52 vorgesehen ist. Der zweite Dichtungsring 52 drückt in der Nachbarschaft der Noppe 22 der Stromschiene 18 gegen diese.

Bei dem in Figur 2 gezeichneten Ausführungsbeispiel ist die umlaufende Ausnehmung 36 im zweiten Gehäuseteil 14 von einer Aussparung 38 gebildet, die zur axial abdichtenden Verspannung des Dichtungsringes 34 eine einzige radial orientierte Ringfläche 40 und eine axial orientierte Grundfläche 42 aufweist. Desgleichen ist es möglich, dass die umlaufende Ausnehmung 36 im zweiten Gehäuseteil 14, d.h. in dessen Loch 32, von einer Rille gebildet ist, die zur radial abdichtenden Verspannung des Dichtungsringes 34 zwei sich gegenüber liegende, d.h. axial voneinander beabstandete, radial orientierte Ringflächen und eine diese miteinander verbindende axial orientierte Grundfläche aufweist.

Der jeweiligen Stromschiene 18 ist ein Befestigungselement 44 zugeordnet, das einen an der Innenfläche 46 der Noppe 22 anliegenden Widerlagerabschnitt 48 und einen vom Widerlagerabschnitt 48 einstückig wegstehenden Gewindezapfen 50 aufweist, der aus dem zentralen Durchgangsloch 28 des Kontaktring-Stirnflächenabschnittes 26 der Noppe 22 vorsteht.

Gleiche Einzelheiten sind in den Figuren 1 bis 3 jeweils mit denselben Bezugsziffern bezeichnet, so dass es sich erübrigt, in Verbindung mit den Figuren alle Einzelheiten jeweils detailliert zu beschreiben.

### Bezugsziffernliste -:

- 10: elektrisches Bauteil
- 12: erstes Gehäuseteil (von 10)
- 14: zweites Gehäuseteil (von 10)
- 16: Gehäuse (von 10)
- 18: Stromschienen (von 10)
- 20: Grundfläche (von 18)
- 22: Noppe (von 18)
- 24: kreiszylindrischer Mantelabschnitt (von 22)
- 26: Kontaktring-Stirnflächenabschnitt (von 22)
- 28: Durchgangsloch (in 26)
- 30: Kontaktfläche (von 26)
- 32: Loch (in 14 für 22)
- 34: Dichtungsring (zwischen 22 und 14)
- 36: Ausnehmung (in 14 für 34)
- 38: Aussparung (von 36)
- 40: radial orientierte Ringfläche (von 38)
- 42: axial orientierte Grundfläche (von 38)
- 44: Befestigungselement (von 10 bei 22)
- 46: Innenfläche (von 22)
- 48: Widerlagerabschnitt (von 44)
- 50: Gewindezapfen (von 44)
- 52: zweiter Dichtungsring (in 54)
- 54: Rinne (in 12)

## Patentansprüche

1. Elektrisches Bauteil mit mindestens einer Stromschiene (18) mit einem Durchgangsloch (28), die zwischen einem ersten und einem zweiten Gehäuseteil (12, 14) vorgesehen ist, wobei das zweite Gehäuseteil (14) ein Loch (32) aufweist, aus dem die Stromschiene (18) mit ihrer Kontaktfläche vorsteht und mit einem äußeren Stromanschluss-Element kontaktierbar ist, und wobei ein Befestigungselement (44) zur mechanisch festen Anschluss-Kontaktierung des Stromanschlusselementes an der Stromschiene (18) vorgesehen ist,
**dadurch gekennzeichnet, dass**
die Stromschiene (18) mit einer aus ihrer Grundfläche (20) heraus ragenden Noppe (22) ausgebildet ist, die einen kreiszylindrischen Mantelabschnitt (24) und einem kreisrunden Kontaktring-Stirnflächenabschnitt (26) aufweist, der Kontaktring-Stirnflächenabschnitt (26) von der Grundfläche (20) eine definierte Höhenabmessung besitzt, so dass die Noppe (22) mit einer Kontaktfläche (30) des Kontaktring-Stirnflächenabschnitts (26) aus dem Loch (32) des zweiten Gehäuseteils (14) definiert vorsteht, wobei:
das Durchgangsloch (28) auf dem Kontaktring-Stirnflächenabschnitt (26) ausgebildet ist; das Befestigungselement (44) sich durch das Durchgangsloch (28) des Kontaktring-Stirnflächenabschnitt (26) der Noppe (22) hindurch erstreckt und aus der Noppe (22) vorsteht um das Stromanschlusselement an der Kontaktfläche (30) der Noppe (22) zu befestigen; und
das Loch (32) des zweiten Gehäuseteils (14) eine umlaufende Ausnehmung (36) aufweist, in der ein Dichtungsring (34) abdichtend vorgesehen ist.

2. Elektrisches Bauteil nach Anspruch 1,
**dadurch gekennzeichnet,**
**dass** die Noppe (22) und die Stromschiene (18) materialeinstückig ausgebildet sind.

3. Elektrisches Bauteil nach Anspruch 1,
**dadurch gekennzeichnet,**
**dass** die Stromschiene (18) einen länglich rechteckigen Querschnitt mit einer bestimmten Schienenbreite besitzt, und dass der kreiszylindrische Mantelabschnitt (24) der Noppe (22) einen Durchmesser besitzt, der kleiner ist als die Schienenbreite.

4. Elektrisches Bauteil nach Anspruch 1,
**dadurch gekennzeichnet,**
**dass** das Durchgangsloch (28) im Zentrum des Kontaktring-Stirnflächenabschnittes (26) der Noppe (22) ausgebildet ist.

5. Elektrisches Bauteil nach Anspruch 4,
**dadurch gekennzeichnet**
**dass** das Befestigungselement (44) einen Widerlagerabschnitt (48) aufweist, der an der Innenfläche (46) der Noppe (22) anliegt.

6. Elektrisches Bauteil nach Anspruch 4 oder 5,
**dadurch gekennzeichnet,**
**dass** das Befestigungselement (44) einen Gewindezapfen (50) aufweist, der aus dem zentralen Durchgangsloch (28) des Kontaktring-Stirnflächenabschnittes (26) der Noppe (22) vorsteht.

7. Elektrisches Bauteil nach Anspruch 1,
**dadurch gekennzeichnet**
**dass** die umlaufende Ausnehmung (36) im Loch (32) des zweiten Gehäuseteils (14) von einer Rille gebildet ist, die zur radial abdichtenden Verspannung des Dichtungsringes (34) zwei sich gegenüber liegende radial orientierte Ringflächen (40) und eine axial orientierte Grundfläche (42) aufweisen.

8. Elektrisches Bauteil nach Anspruch 1,
**dadurch gekennzeichnet,**
**dass** die umlaufende Ausnehmung (36) im Loch (32) des zweiten Gehäuseteils (14) von einer Aussparung (38) gebildet ist, die zur axial abdichtenden Verspannung des Dichtungsringes (34) eine radial orientierte Ringfläche (40) und eine axial orientierte Grundfläche (42) aufweist.

9. Elektrisches Bauteil nach einem der Ansprüche 1 bis 8,
**dadurch gekennzeichnet,**
**dass** das erste Gehäuseteil (12) mit einer ringförmigen Rinne (54) ausgebildet ist, in der ein zweiter Dichtungsring (52) vorgesehen ist, der in der Nachbarschaft der Noppe (22) gegen die Stromschiene (18) drückt.

## Claims

1. An electrical component with at least one power rail (18) with a clearance hole (28), which is provided between a first and a second part of the housing (12, 14), wherein
the second part of the housing (14) has a hole (32), out of which protrudes the power rail (18) with its contact face, and which can be brought into contact with an external power supply connector element, and wherein
a fastening element (44) is provided to ensure a mechanically secure connecting contact between the power supply connector element and the power rail (18),
**characterised in that** the power rail (18) is designed with a stud (22) projecting from its base face (20), which stud has a cylindrical casing section (24) and a circular contact ring end face section (26), the contact ring end face section (26) possessing a defined height dimension from the base face (20) such that the stud (22) with a contact face (30) of the contact ring end face section (26) protrudes out of the hole (32) of the second part of the housing (14) in a defined manner, wherein:
the clearance hole (28) is designed on the contact ring end face section (26); the fastening element (44) extends through the clearance hole (28) of the contact ring end face section (26) of the stud (22) and protrudes out of the stud (22) so that the power supply connector element can be attached to the contact face (30) of the stud (22), and the hole (32) of the second part of the housing (14) has a circumferential recess (36), in which a ring seal (34) provides a sealing function.

2. The electrical component in accordance with claim 1,
**characterised in that** the stud (22) and the power rail (18) are integrally designed from the same material.

3. The electrical component in accordance with claim 1,
**characterised in that** the power rail (18) possesses an elongated rectangular cross-section with a certain rail width, and that the cylindrical casing section (24) of the stud (22) possesses a diameter that is smaller than the rail width.

4. The electrical component in accordance with claim 1,
**characterised in that** the clearance hole (28) is designed in the centre of the contact ring end face section (26) of the stud (22).

5. The electrical component in accordance with claim 4,
**characterised in that** the fastening element (44) has an abutment section (48), which abuts onto the inner face (46) of the stud (22).

6. The electrical component in accordance with claim 4 or 5,
**characterised in that** the fastening element (44) has a threaded pin (50), which protrudes out of the central clearance hole (28) of the contact ring end face section (26) of the stud (22).

7. The electrical component in accordance with claim 1,
**characterised in that** the circumferential recess (36) in the hole (32) of the second part of the housing (14) is formed as a groove, which for purposes of pre-loading of the ring seal (34) to provide radial sealing has two opposing radially-oriented annular faces (40) and one axially-oriented base face (42).

8. The electrical component in accordance with claim 1,
**characterised in that** the circumferential recess (36) in the hole (32) of the second part of the housing (14) is formed from a relief (38), which for purposes of pre-loading the ring seal (34) to provide axial sealing has one radially-oriented annular face (40) and one axially-oriented base face (42).

9. The electrical component according to one of the claims 1 to 8,
**characterised in that** the first part of the housing (12) is designed with an annular channel (54) in which a second ring seal (52) is provided, which in the proximity of the stud (22) presses against the power rail (18).

## Revendications

1. Composant électrique comprenant au moins un rail électrique (18) avec un trou de passage (28), qui est prévu entre une première partie de boîtier et une seconde partie de boîtier (12, 14), la seconde partie de boîtier (14) présentant un trou (32) duquel le rail électrique (18) dépasse par sa surface de contact et peut être mis en contact avec un élément extérieur de raccordement électrique, et un élément de fixation (44) étant prévu pour la mise en contact de raccordement fixe au plan mécanique de l'élément de raccordement électrique sur le rail électrique (18),
**caractérisé en ce que**
le rail électrique (18) est conçu avec une nope (22) dépassant de sa surface de base (20), laquelle présente une partie d'enveloppe (24) cylindrique circulaire et une partie de surface avant de bague de contact (26) circulaire, la partie de surface frontale de bague de contact (26) de la surface de base (20) présentant une dimension de hauteur définie, de sorte que la nope (22) dépasse de façon définie avec une surface de contact (30) de la partie de surface frontale de bague de contact (26) du trou (32) de la seconde partie de boîtier (14),
le trou de passage (28) étant conçu sur la partie de surface frontale de bague de contact (26), l'élément de fixation (44) s'étendant à travers le trou de passage (28) de la partie de surface frontale de bague de contact (26) de la nope (22) et dépassant de la nope (22) pour fixer l'élément de raccordement électrique sur la surface de contact (30) de la nope (22) ; et
le trou (32) de la seconde partie de boîtier (14) présentant un évidement (36) périphérique dans lequel une bague d'étanchéité (34) est prévue de façon étanche.

2. Composant électrique selon la revendication 1,
**caractérisé en ce que**
la nope (22) et le rail électrique (18) sont conçus d'une seule pièce au niveau du matériau.

3. Composant électrique selon la revendication 1,
**caractérisé en ce que**,
le rail électrique (18) présente une section rectangulaire dans le sens de la longueur avec une largeur de rail définie, et **en ce que** la partie d'enveloppe (24) cylindrique circulaire de la nope (22) a un diamètre qui est inférieur à la largeur du rail.

4. Composant électrique selon la revendication 1,
**caractérisé en ce que**
le trou de passage (28) est conçu au centre de la partie de surface frontale de la bague de contact (26) de la nope (22).

5. Composant électrique selon la revendication 4,
**caractérisé en ce que**
l'élément de fixation (44) présente une partie de palier de butée (48) qui est adjacente à la surface intérieure (46) de la nope (22).

6. Composant électrique selon la revendication 4 ou 5,
**caractérisé en ce que**
l'élément de fixation (44) présente un tenon fileté (50) qui dépasse du trou de passage (28) central de la partie de surface frontale de bague de contact (26) de la nope (22).

7. Composant électrique selon la revendication 1,
**caractérisé en ce que**,
l'évidement (36) périphérique dans le trou (32) de la seconde partie de boîtier (14) est formé par une rainure qui, pour le serrage étanchéifiant radialement de la bague d'étanchéité (34), présente deux surfaces annulaires (40) orientées radialement et se faisant face et une surface de base (42) orientée axialement.

8. Composant électrique selon la revendication 1,
**caractérisé en ce que**
l'évidement (36) périphérique dans le trou (32) de la seconde partie de boîtier (14) est formé par un évidement (38) qui, pour le serrage étanchéifiant axialement de la bague d'étanchéité (34), présente une surface annulaire (40) orientée radialement et une surface de base (42) orientée axialement.

9. Composant électrique selon l'une quelconque des revendications 1 à 8,
**caractérisé en ce que**
la première partie de boîtier (12) est conçue avec une rainure (54) de forme annulaire dans laquelle est prévue une seconde bague d'étanchéité (52) qui appuie contre le rail électrique au voisinage de la nope (22).
